# FASCICULE DE BREVET EUROPEEN

(11) **EP 0 951 147 B1**
(45) Date de publication et mention de la délivrance du brevet: **28.03.2007**
(21) Numéro de dépôt: 99201099.1
(22) Date de dépôt: 07.04.1999
(51) Int. Cl.: H04B 1/18

(54) **Appareil radioélectrique comportant un récepteur et procédé pour régler l'un des étages amplificateurs haute fréquence d'un récepteur**
Empfänger und ein Verfahren zür Abstimmung von einer der Hoghfrequenzstufen in einem Empfänger
Receiver and a method for tuning one of the radio frequency stages in a receiver

(30) Priorité: 16.04.1998 FR 9804730
(43) Date de publication de la demande: 20.10.1999
(73) Titulaire: Koninklijke Philips Electronics N.V., 5621 BA Eindhoven (NL)
(72) Inventeur: Rousselin, Samuel, 75008 Paris (FR); Di Capua, Luigi, 75008 Paris (FR)
(74) Mandataire: Pennings, Johannes

(56) Documents cités:
- EP-A- 0 546 723
- EP-A- 0 691 738
- US-A- 4 186 360

## Description

La présente invention concerne un appareil radioélectrique comportant une partie réception formée par au moins :
- un étage amplificateur sélectif haute fréquence muni d'un circuit sélectif accordable sur une certaine bande de fréquence.

L'invention concerne aussi un procédé pour régler un des étages amplificateurs haute fréquence contenu dans un tel appareil.

De tels appareils sont bien connus et trouvent de nombreuses applications, notamment dans le domaine des appareils de téléphonie portable. Il est nécessaire pour ce genre d'appareil d'avoir un récepteur sensible ce qui augmente sa portée. L'utilisation d'amplificateur sélectif améliore la sensibilité.

Un problème qui se pose avec de tels appareils, est l'accord de cet amplificateur sélectif. En cours de fabrication, on utilise des composants dont les valeurs présentent une certaine dispersion. On se trouve alors confronté au fait que la fréquence d'accord des amplificateurs sélectifs varie d'un exemplaire à l'autre en fin de fabrication et varie aussi en fonction de la température. Pour compenser cela, il est d'usage de prévoir un condensateur de réglage et d'agir sur sa valeur afin que le circuit sélectif soit bien accordé sur la bande de fréquences dans laquelle il doit travailler. Une compensation en température est décrite dans le document de brevet japonais publié le 24.01.1995 sous le numéro 07022974. Cette compensation agit sur une diode à capacité variable qui accorde aussi le circuit oscillant de sorte que la variation totale que l'on peut appliquer à cette diode est obérée de cette compensation.

Le document EP-A 0 546 723 décrit aussi un circuit sélectif accordable par une grandeur de commande. Le réglage de ce circuit est effectué pendant le fonctionnement de l'appareil auquel il est rattaché. On n'est pas confronté au problème de réglage des appareils en fin de fabrication.

La présente invention propose un appareil du genre mentionné dans le préambule dans lequel on a prévu des moyens pour faciliter l'accord de l'étage sélectif sans utiliser de mesureur de température notamment et des moyens pour maintenir la dynamique de la tension applicable à la tension d'accord si le circuit sélectif exige une certaine dynamique dans l'accord de son circuit sélectif.

Pour cela, un tel appareil est remarquable en ce qu'il est prévu :
- un mesureur de niveau reçu pour mesurer le niveau reçu des signaux émis par un oscillateur de référence placé à l'extérieur dudit appareil et mis en oeuvre en fin de fabrication dudit appareil,
- un organe de variation pour faire varier ladite bande de fréquence en fonction d'une grandeur de commande, organe comprenant une pluralité d'éléments réactifs et un réseau de connexion pour brancher sur le circuit sélectif accordable au moins un élément réactif dudit ensemble en fonction de ladite grandeur de commande
- un organe de mise en mémoire de la grandeur de commande qui donne le meilleur niveau obtenu par le mesureur de niveau, grandeur de commande utilisée durant le fonctionnement normal dudit appareil.

Une des idées de l'invention est d'insérer dans le circuit sélectif un ou plusieurs éléments réactifs qui permettent de centrer ce circuit sélectif sur la plage de fréquence sur laquelle l'appareil est censé fonctionner.

La description suivante, faite en regard des dessins ci-annexés, le tout donné à titre d'exemple non limitatif, fera bien comprendre comment l'invention peut être réalisée.
La figure 1 montre un appareil conforme à l'invention.
La figure 2 montre le détail de réalisation de l'invention.
La figure 3 est un organigramme destiné à expliciter le fonctionnement de l'invention.

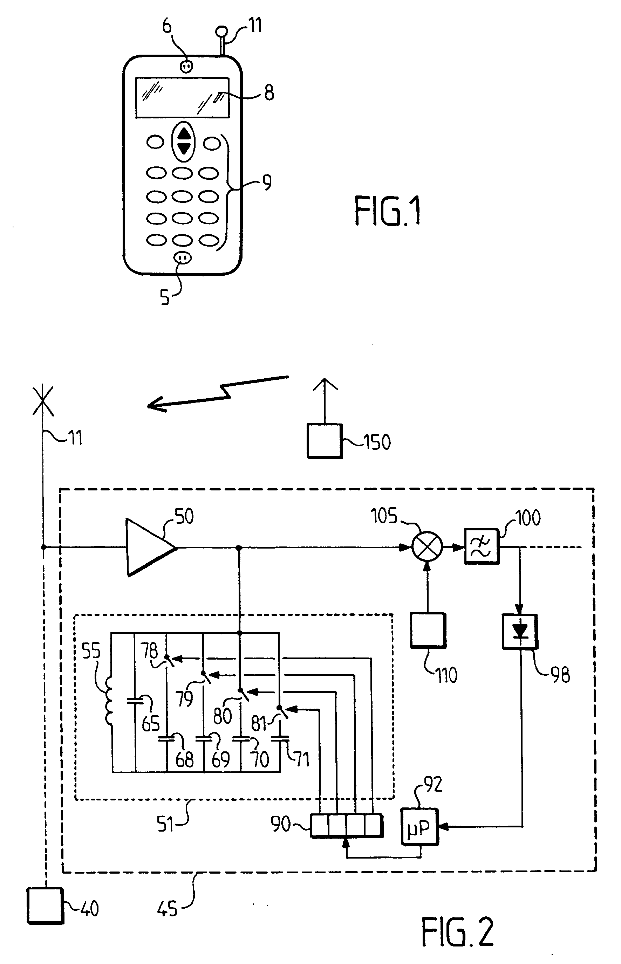

A la figure 1, on a représenté un appareil électronique conforme à l'invention. Dans le cadre de l'exemple décrit c'est un appareil téléphonique sans fil du genre CT0 ou autres. Il est composé d'un microphone 5, d'un écouteur 6, d'un écran 8, d'un clavier 9 et d'une antenne 11. Cet appareil se raccorde à sa base, non représentée sur la figure, en utilisant un canal de fréquence. Il est à noter que l'invention peut aussi s'appliquer à la base elle-même.

La figure 2 montre d'un côté la partie émission 40, non détaillée car ne faisant pas partie de l'invention et la partie réception 45. C'est dans cette partie réception que se trouve l'amplificateur sélectif qui est le préamplificateur haute fréquence. Cet amplificateur est représenté schématiquement sur cette figure par un amplificateur 50, proprement dit, à la sortie duquel un circuit sélectif 51 du genre circuit bouchon est prévu. Ce circuit bouchon est formé par une bobine de self induction 55 aux extrémités de laquelle est branché un condensateur principal 65 qui fixe en première approximation la fréquence d'accord de ce circuit bouchon. Ce condensateur peut être aussi une diode à capacité variable.

Selon l'invention, pour faire varier la fréquence d'accord de ce circuit sélectif, d'autres condensateurs 68, 69, 70 et 71 sont prévus. Pour cela, ils peuvent être mis en parallèle sur le condensateur principal 65 par un circuit de connexion constitué par des circuits interrupteurs 78, 79, 80 et 81 respectivement. La position ouverte ou fermée de ces circuits interrupteurs est déterminée par le contenu d'un compteur 90. Le contenu de ce compteur 90 s'incrémente sous la commande d'un microprocesseur 92, ainsi que sa mise à zéro. Ainsi, l'ensemble formé par les condensateurs 68, 69, 70 et 71, les circuits interrupteurs 78, 79, 80 et 81 constitue un organe de variation de la fréquence d'accord commandé par le contenu du compteur 90. Ce microprocesseur reçoit aussi un signal en provenance d'un détecteur de niveau 98. Ce détecteur de niveau est branché à la sortie d'un filtre de moyenne fréquence 100. Ce filtre met en évidence un signal de moyenne fréquence obtenu par un mélangeur 105 qui effectue le mélange des signaux fournis par l'amplificateur sélectif 50 muni du circuit bouchon 51 et d'un oscillateur local 110. Pour effectuer le réglage de la capacité à mettre en parallèle au condensateur principal 65, on utilise un émetteur de référence 150. Les différents condensateurs sont branchés tour à tour en parallèle sur le circuit bouchon. La combinaison appliquée sur ce circuit bouchon qui donne le meilleur niveau reçu est emmagasinée, par exemple, en figeant le contenu du compteur 90.

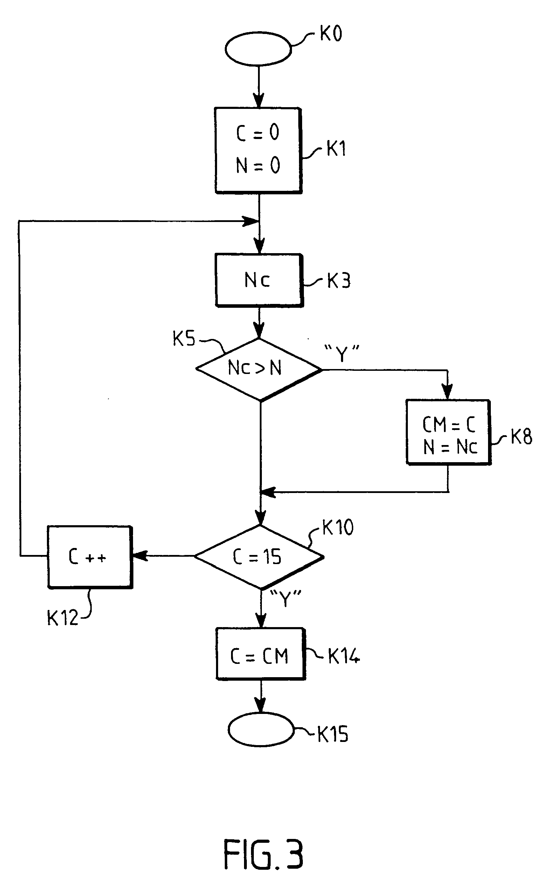

La figure 3 est un organigramme qui explicite le fonctionnement de l'invention. La case K0 indique l'entrée du processus de réglage de la valeur des capacités à insérer dans le circuit oscillant 51. Ce processus est mis en oeuvre principalement par le microprocesseur 92. La case K1 indique l'initialisation de deux variables : tout d'abord la variable C qui est le contenu du compteur 90, c'est-à-dire que le contenu de ce compteur 90 est mis à zéro, et une variable N destinée à contenir la valeur du niveau mesuré par le détecteur 98. A la case K3, on recueille la valeur du niveau détecté. Ce niveau est dû à l'émission de l'émetteur de référence 105 mis en route au préalable. Ce niveau est ensuite comparé comme indiqué à la case K5 avec le niveau enregistré dans la variable N. Si le niveau Nc qui vient d'être fourni est supérieur à la valeur déjà enregistrée, alors cette dernière valeur de Nc est emmagasinée dans la variable N. En outre la valeur du contenu du compteur 90 est stockée dans une variable CM (case K8). Après l'opération effectuée dans la case K8 et si le test indiqué à la case K5 est négatif, alors on effectue un test sur le contenu C du compteur 90. On teste donc si ce contenu est égal à 15, case K10, ce qui correspond à un compteur à 4 positions qui compte, en binaire, de 0000 à 1111. Si le contenu de 15 n'est pas obtenu, alors on incrémente ce compteur d'une unité, case K12. Si ce contenu est égal à 15, alors on charge la valeur CM qui est associée donc au plus haut niveau détecté, case K14. La case K15 marque la fin de l'exécution du programme après l'opération de la case K14. Les valeurs C68, C69, C70 et C71 des condensateurs 68, 69, 70 et 71 respectivement sont doubles l'une de l'autre telles que :
C68 = 1.CO
C69 = 2.CO
C70 = 4.CO
C71 = 8.CO
de sorte que toutes les valeurs de 0.CO à 15.CO sont obtenues lorsque le contenu du compteur 90 varie de 0 à 15, CO étant l'unité de base pour ces différents condensateurs.

En variante, il est possible que des contenus du compteur 90 soient mémorisés pour différentes fréquences élaborées par l'oscillateur de référence 150 de sorte que l'on puisse s'ajuster sur les différentes porteuses que l'appareil peut recevoir.

Bien que l'on ait cité des condensateurs pour régler le circuit oscillant, on peut aussi utiliser des éléments réactifs réalisés par des self inductances sans pour cela sortir du cadre de l'invention.

## Revendications

1. Appareil radioélectrique comportant une partie réception formée par au moins :
- un étage amplificateur sélectif haute fréquence muni d'un circuit sélectif accordable sur une certaine bande de fréquence,
**caractérisé en ce qu'**il est prévu :
- un mesureur de niveau reçu pour mesurer le niveau reçu des signaux émis par un oscillateur de référence placé à l'extérieur dudit appareil et mis en oeuvre en fin de fabrication dudit appareil,
- un organe de variation pour faire varier ladite bande de fréquence en fonction d'une grandeur de commande, organe comprenant une pluralité d'éléments réactifs et un réseau de connexion pour brancher sur le circuit sélectif accordable au moins un élément réactif dudit ensemble en fonction de ladite grandeur de commande
- un organe de mise en mémoire de la grandeur de commande qui donne le meilleur niveau obtenu par le mesureur de niveau, grandeur de commande utilisée durant le fonctionnement normal dudit appareil.

2. Appareil selon la revendication 1 **caractérisé en ce que** l'organe de variation est formé en outre d'un compteur pour connecter tour à tour chacun et toute combinaison de groupement d'éléments réactifs.

3. Appareil selon la revendication 1 ou 2, **caractérisé en ce que** les éléments réactifs sont des condensateurs.

4. Procédé pour régler au moins l'un des étages amplificateurs haute fréquence d'un récepteur, muni d'un circuit sélectif, procédé mis en oeuvre dans un appareil selon l'une des revendications 1 à 3 **caractérisé en ce que** pour déterminer la connexion d'éléments réactifs de correction pour le circuit sélectif, il comporte les étapes suivantes :
- application d'un signal d'un oscillateur de référence,
- connexion tour à tour de chaque élément réactif et/ou toute combinaison de groupement d'éléments réactifs,
- mesure du niveau reçu en sortie du circuit amplificateur,
- mémorisation de l'élément ou du groupement donnant le meilleur niveau.

## Claims

1. A radio device comprising a receiving part formed by at least:
- a selective high-frequency amplifier stage including a selective circuit that can be tuned to a certain frequency band,
**characterized in that** there is provided:
- a received level meter for measuring the received level of the signals transmitted by a reference oscillator placed on the outside of said device and used at the end of the manufacture of said device,
- a variation element for causing said frequency band to vary as a function of a control magnitude, the element comprising a plurality of reactive elements and a connecting network to connect to the selective tuning circuit at least one reactive element of said set as a function of said control magnitude,
- a storage element for storing the control magnitude that gives the best level obtained by the level meter, which control magnitude is used during the normal operation of said device.

2. A device as claimed in claim 1, **characterized in that** the variation element is further formed by a counter for alternately connecting each and every combination of groups of reactive elements.

3. A device as claimed in claim 1 or 2, **characterized in that** the reactive elements are capacitors.

4. A method of adjusting at least one of the high-frequency amplifier stages of a receiver, including a selective circuit, the method being implemented in a device as claimed in one of the claims 1 to 3, **characterized in that** for determining the connection of reactive correction elements for the selective circuit, it comprises the following steps:
- application of a signal of a reference oscillator,
- alternate connection of each reactive element and/or each and every combination of groups of reactive elements,
- measurement of the level received on the output of the amplifier circuit,
- storage of the element or of the group giving the best level.

## Patentansprüche

1. Radioelektrisches Gerät mit einem Empfängerteil, der zumindest gebildet wird von:
- einer selektiven Hochfrequenzverstärkerstufe, die mit einem selektiven Kreislauf ausgestattet ist, der auf ein bestimmtes Frequenzband abstimmbar ist,
**dadurch gekennzeichnet, dass** vorgesehen ist:
- ein Eingangsniveaumesser zur Messung des empfangenen Niveaus der von einem Bezugsschwinger übermittelten Signale, der außerhalb des Geräts angeordnet und am Ende der Fertigung des Geräts ausgeführt wird,
- ein Schwankungsglied zur Gewährleistung der Schwankung des Frequenzbands in Abhängigkeit einer Steuerungsgröße, wobei dieses Schwankungsglied eine Vielzahl reaktiver Elemente und ein Verbindungsnetz zum Anschluss von zumindest einem reaktiven Element des Bausatzes in Abhängigkeit von dieser Steuerungsgröße an den abstimmungsfähigen selektiven Kreislauf umfasst,
- ein Speicherungsglied der Steuerungsgröße, das das mit dem Niveaumesser besterreichte Niveau vorgibt, die während des Normalbetriebs des Geräts verwendete Steuerungsgröße.

2. Gerät nach Anspruch 1, **dadurch gekennzeichnet, dass** das Schwankungsglied darüber hinaus von einem Zähler gebildet wird, um nach und nach alle und jede Sammelverbindung reaktiver Elemente anzuschließen.

3. Gerät nach Anspruch 1 oder 2, **dadurch gekennzeichnet, dass** die reaktiven Elemente Kondensatoren sind.

4. Verfahren zur Regelung von zumindest einer der Hochfrequenzverstärkerstufen eines Empfängers, der mit einem selektiven Kreislauf versehen ist, wobei das Verfahren in einem Gerät nach einem der Ansprüche 1 bis 3 ausgeführt wird, **dadurch gekennzeichnet, dass** es zur Bestimmung der Verbindung reaktiver Berichtigungselemente für den selektiven Kreislauf die nachstehenden Etappen umfasst:
- Anwendung des Signals eines Bezugsschwingers
- nach und nach Verbindung jedes reaktiven Elements und/oder jeder Sammelverbindung reaktiver Elemente
- Messung des am Ausgang des Verstärkerkreislaufs erhaltenen Niveaus
- Speicherung des Elements oder der Sammelverbindung, die das beste Niveau bietet.
